# EUROPEAN PATENT APPLICATION

(11) **EP 4 080 761 A1**
(43) Date of publication of application: **26.10.2022**
(21) Application number: 20900734.3
(22) Date of filing: 06.11.2020
(51) Int. Cl.: H03F 1/30, H03F 1/32

(54) **ANALOG FRONT-END CIRCUIT FOR BIOELECTRIC SENSOR**

(30) Priority: 20.12.2019 CN 201911322690; 03.07.2020 CN 202010635789
(71) Applicant: CYZURTECH(SHANGHAI) CO.,LTD.,, 201203 Shanghai (CN)
(72) Inventor: DENG, Chenxi, 201203 Shanghai (CN)
(74) Representative: ABG Intellectual Property Law, S.L.
(86) International application number: PCT/CN2020/127058
(87) International publication number: WO 2021/120918

(57) **Abstract**

Provided is an analog front-end circuit for a bioelectric sensor, which includes two feedforward amplifiers (13a, 13b) and respective feedback networks (12a, 12b), an output common-mode voltage detector (23), an error amplifier (22), a leakage current compensator (200) and resistance voltage dividers (R10, R11; R27, R28). Common-mode components of various types of leakage currents can be effectively suppressed.

## Description

### Technical Field

The present application relates to the field of integrated circuits, in particular to an analog front-end circuit for a bioelectric sensor.

### Background Art

Instrument amplifier is a kind of precision differential voltage amplifier, which can provide high common-mode suppression ability and avoid the interference of large industrial power frequency (50Hz/60Hz power frequency) in the environment. This interference is superimposed on a small differential signal to be measured to form the common-mode-part of the overall input signal, which usually reaches several Vpp or even tens of Vpp. The instrument amplifier also provides a high matching input impedance to avoid the problem that the differential signal cannot be extracted due to the load partial voltage effect on the input signal source. In addition, the high input impedance can also reduce the problem of common-mode suppression caused by the impedance mismatch of the differential signal source. The differential signal to be measured is amplified within the required bandwidth, while other components outside the bandwidth are suppressed. Therefore, the instrument amplifier sometimes needs to integrate the filtering function, that is, resistors and capacitors are added to construct the zero pole. Sometimes, especially in the field of bioelectricity, the signal has a small bandwidth frequency lower limit, such as less than 1Hz, which requires a large combination of resistors and capacitors.

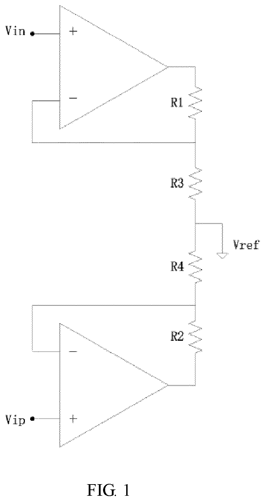

The structure of a classical instrument amplifier is as illustrated in FIG. 1. A symmetrical circuit is formed through two feedforward amplifiers and resistors R1, R2, R3 and R4. The resistances of R1 and R2 are equal, the resistances of R3 and R4 are equal, and the resistors R1, R3, R4 and R2 are connected in series between the output ends of the two feedforward amplifiers. A positive input end of one feedforward amplifier is connected with a first signal Vin of the differential input signal, and a negative input end is connected with a connection node of resistors R1 and R3. A positive input end of the other feedforward amplifier is connected with a second signal Vip of the differential input signal, and a negative input end is connected with a connection node of resistors R2 and R4. The connection node of resistors R3 and R4 is connected with a fixed reference voltage Vref. The instrument amplifier with the above structure can provide a high matching input impedance to avoid the impedance of the input source having a great impact on the common-mode suppression of the system. The circuit symmetry can avoid the environment such as temperature, process and so on having a great impact on the amplification of the differential signal. When the resistance of R1 is set to be greater than the resistance of R3, the differential signal can be provided with an amplification gain, but the common-mode signal will be amplified by the same multiple at the same time, which is not conducive to the overall common-mode suppression.

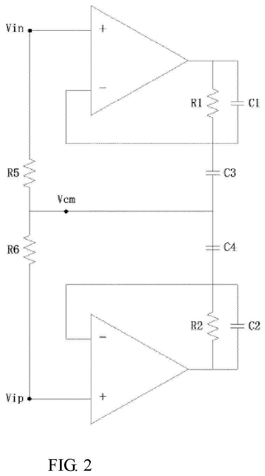

As illustrated in FIG. 2, it is an improved structure of the instrument amplifier when applied to the bioelectric field, which includes two feedforward amplifiers, resistors R1, R2, R5, R6, and capacitors C1, C2, C3, C4. Compared with the circuit in FIG. 1, the original resistors R3 and R4 are replaced by capacitors C3 and C4 in the improved structure, so that R1, C3, C4 and R2 are connected in series between the output ends of the two feedforward amplifiers, R1 is connected in parallel with C1, and R2 is connected in parallel with C2. The original fixed reference voltage Vref is also replaced by the common-mode input voltage Vcm divided by symmetrical resistors R5 and R6. Resistors R5 and R6 are connected in series between the positive input ends of the two feedforward amplifiers. The voltage of the connection node of R5 and R6 corresponds to the common-mode input voltage Vcm, which is connected with the connection node of capacitors C3 and C4.

The improved structure eliminates the disadvantages of the classical structure of the instrument amplifier, that is, while amplifying the differential signal, the common-mode signal will not be amplified but will be followed in the form of unit gain, and the overall common-mode suppression can be improved. The replacement of capacitors C3 and C4 realizes the integration of high-pass filtering functions. R1 and C1 (R2 and C2) form high-pass corner frequency. If the impedance relationship between capacitors is set as C1 = C2 > C3 = C4, the differential AC signal above the high-pass frequency point will be amplified by corresponding multiples. However, in order to avoid the reduction of input impedance due to the setting of R5 and R6, a large resistance should be designed for R5 and R6. In addition, when applied in the field of bioelectricity, the high-pass corner frequency of some bioelectric signals such as ECG (electrocardiogram) and EEG (electroencephalogram) is very small (often less than 1Hz), resulting in a large product of R1 and C1. In order to avoid capacitor external connection, it is also necessary to set a large resistance for R1 and R2.

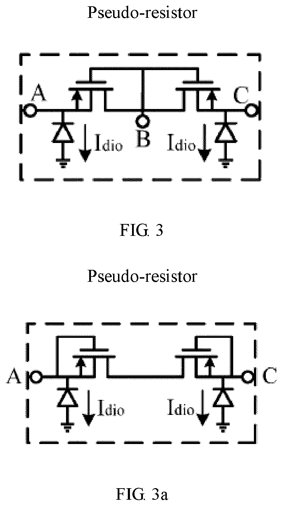

Pseudo-resistor is a kind of structure with large equivalent resistance and similar function to resistor in the form of non-resistive devices (such as MOS transistors). In the classical pseudo-resistor structure, PMOS transistors connected by two diodes are symmetrical left and right, and connected back to back to form a pseudo-resistor. FIG. 3 and FIG. 3a are examples of back-to-back connection of two PMOS transistors. In the form of pseudo-resistor, equivalent resistance in the range of hundreds of megaohms (MΩ) to gigaohms (GΩ) or even teraohms (TΩ) can be achieved by selecting MOS transistors with different Vth or gate oxygen thickness, or adjusting the width-length ratio of MOS transistors.

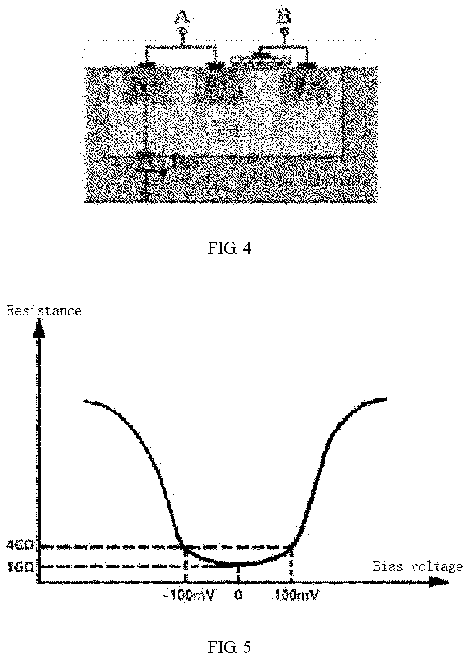

However, the large resistor or pseudo-resistor (such as R1 and R2 in the improved structure) with the above ultra-high resistance will make the instrument amplifier sensitive to leakage. Under the low power supply voltage process, leakage will cause a large bridging voltage at both ends of the large resistor, which will seriously affect the DC working point of the instrument amplifier and further affect the normal working amplification. One kind of leakage current comes from the pseudo-resistor based on MOS transistors. As can be seen from the device profile in FIG. 4, for PMOS, a parasitic diode is formed between the N-well and the P-type substrate, the positive electrode of the diode is connected with the P-type substrate, and the negative electrode is connected with the PMOS source node A, thus generating the reverse bias diode leakage current from the node A to the ground, i.e., I_{dio}. Another kind of leakage current comes from the leakage of the differential input signal to the gate of the MOS device. In the acquisition circuit of bioelectric signals, in order to reduce the flicker noise which is the dominant factor, a very large input differential pair tube is usually designed at the feedforward amplifier, thus generating a large gate leakage current, i.e., I_{gate-p}. The difference between the two leakage currents is ΔI. It will flow through the pseudo-resistor bridged at the negative feedback of the capacitor, resulting in a voltage offset between the negative input end and the output end of the feedforward amplifier. Due to the super-high resistance of the bridged pseudo resistor, the voltage offset is easy to cause the output saturation of the feedforward amplifier, which reduces the DC gain and the closed-loop gain. The uncertain bridging voltage at both ends of the pseudo-resistor will also affect its equivalent resistance in case of small signals, as illustrated in FIG. 5. It is assumed that when the bias voltage is 100mV, its equivalent resistance increases to 4GQ, while the equivalent resistance at normal bias voltage 0V is 1GQ, which are quite different.

A method for partially eliminating the above leakage current is to add a redundant deep N-well NMOS device at the node A of the pseudo-resistor. The device has the same PMOS size, the same bias and the opposite connection mode as the pseudo-resistor, and uses the leakage current of its parasitic diode to compensate the leakage of the parasitic diode of the pseudo-resistor. However, this method has some limitations. First, the input common-mode voltage is locked at half of the supply voltage, which reduces the design freedom and increases the design difficulty of low supply voltage circuits. Second, the process needs to provide P-wells, which makes this method more complex and not suitable for the common single N-well process. Third, the gate leakage current from the input differential pair of the feedforward amplifier cannot be effectively compensated. Fourth, under different process, voltage and temperature conditions, it is difficult to spontaneously compensate the leakage current according to the environmental conditions.

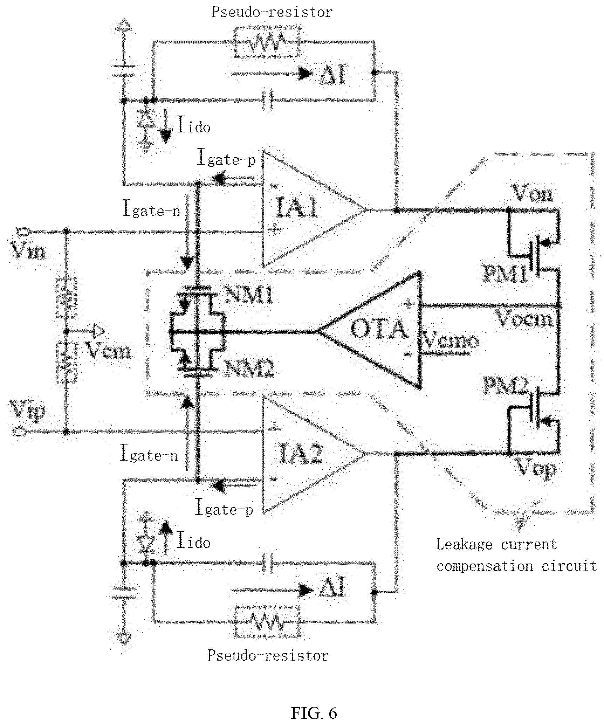

Chinese patent application CN110581691A provides a leakage current compensation circuit for an analog front-end of a biomedical sensor interface chip. As illustrated in FIG. 6, two feedforward amplifiers are set at the analog front-end, each of which forms amplification with fixed gain through capacitor negative feedback, and the corner frequency of the high-pass filter is set below 1Hz by using the ultra-high resistance of the pseudo-resistor. The common-mode voltage at the output ends of the two feedforward amplifiers is extracted by a resistance voltage divider. In order to avoid the DC gain attenuation of the instrument amplifier and the negative impact on the transient output, the ultra-high resistance in the resistance voltage divider is realized by PMOS devices PM1 and PM2 connected by diodes. Agate, a source and a body end of PM1 are connected with each other and connected with the output end of one feedforward amplifier. A gate, a source and a body end of PM2 are connected with each other and connected with the output end of the other feedforward amplifier. Drains of PM1 and PM2 are connected with output common-mode voltage. The output offset of the instrument amplifier is detected thorough an error amplifier or Operational Transconductance Amplifier (OTA), and the corresponding bias voltage is generated to control the leakage current compensator. The leakage current compensator includes NMOS devices NM1 and NM2. Sources, drains and body ends of NM1 and NM2 are connected to receive the control voltage output by the error amplifier or OTA, and gates of NM1 and NM2 are respectively connected with the negative input ends of the two feedforward amplifiers.

The above analog front-end leakage current compensation circuit (CN110581691A) intends to make the gate leakage I_{gate-n} = I_{gate-p}-I_{dio} of NM1 and NM2 through a negative feedback loop, so as to offset the leakage current of the negative input port of the feedforward amplifier, and at the same time, realize the compensation of the MOS based the leakage circuit of the pseudo-resistor and the gate leakage current of the input differential tube of the feedforward amplifier.

On the one hand, in this solution, PM1 and PM2 form two symmetrical large pseudo-resistors for voltage division, but these two pseudo-resistors are in an asymmetric structure, and the characteristics when the voltage at both ends is positive are not completely consistent with those when the voltage at both ends is negative. On the other hand, the applicant of the present application confirmed after simulating the above analog front-end leakage current compensation circuit that the above connection form based on NM1 and NM2 could not generate the current for compensating leakage. In other words, the leakage current of gates of NM1 and NM2 is 0, which cannot produce any effect of compensating leakage current by using voltage-controlled leakage current.

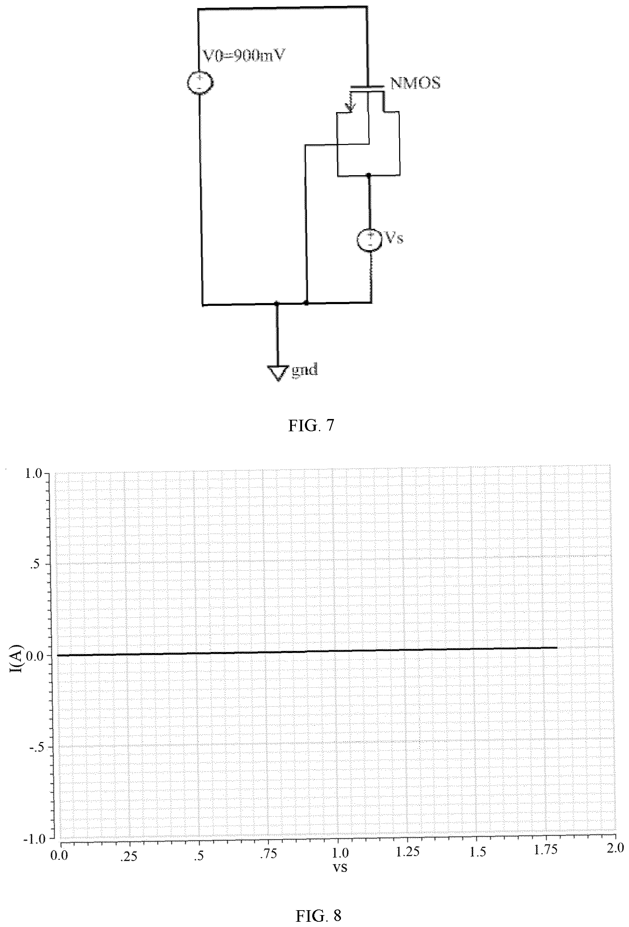

Specifically, first, the circuit shown in FIG. 7 is used to simulate the connection form of NM1 and NM2 in the leakage current compensator: a gate of one NMOS transistor is connected with V0 = 900mV DC voltage, the body end is grounded, the source and drain are connected and control voltage Vs is applied. The DC scanning simulation results show that (see FIG. 8) the gate current of the NMOS transistor remains zero, so it does not have the function of compensating the leakage current.

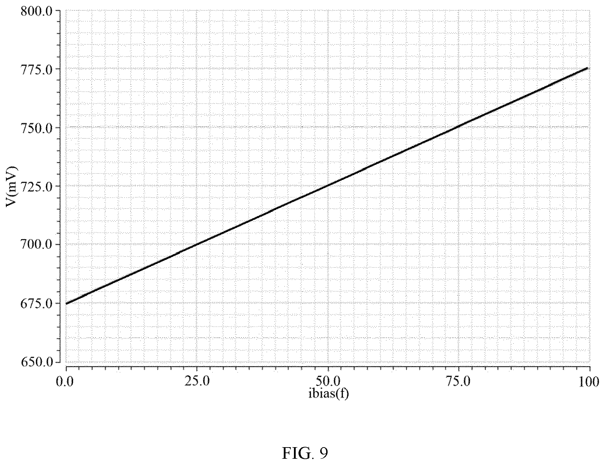

In order to further verify that the solution described in CN110581691A cannot be implemented in fact, the prototype circuit of the above analog front-end is built by using opamp of veriloga as the feedforward amplifier and the basic resistor and capacitor models res and cap. The value of the bridging resistance at the negative feedback of the capacitor is 1TΩ, and the value of the parallel capacitor is 3pF. The differential input signal is set to 675mV DC. By changing the input leakage current parameter i_{bias} of opamp, DC scanning is performed to observe the voltage at the two differential output ends. As illustrated in FIG. 9, as the leakage current increases from zero to 100fA, the differential output voltage also increases linearly to 775mV, that is, the leakage current of the input tube of the feedforward amplifier all flows through the bridged 1TΩ large resistor. It can be seen that this solution does not have any effect of compensating the leakage current.

### Summary

In view of the problems caused by the above leakage current, the present application provides an analog front-end circuit, which can be used in the bioelectric field to realize the common-mode leakage current compensation of the analog front-end of the bioelectric sensor and effectively suppress the common-mode components of a variety of leakage currents.

In order to achieve the purposes, one technical solution of the present application provides an analog front-end circuit for a bioelectric sensor, including a first feedforward amplifier, a first feedback network, a second feedforward amplifier and a second feedback network, wherein the first feedforward amplifier and the second feedforward amplifier are symmetrical to each other; the first feedback network and the second feedback network are symmetrical to each other;
ports of the first feedforward amplifier include a positive input port, a negative input port and an output port; ports of the second feedforward amplifier include a positive input port, a negative input port and an output port;
an input end of the first feedback network is the output port of the first feedforward amplifier, an output end of the first feedback network is the negative input port of the first feedforward amplifier, and the first feedback network includes a first resistor bridged from the input end of the first feedback network to the output end of the first feedback network, and a first capacitor connected with the first resistor in parallel;
an input end of the second feedback network is the output port of the second feedforward amplifier, an output end is the negative input port of the second feedforward amplifier, and the second feedback network includes a second resistor bridged from the input end of the second feedback network to the output end of the second feedback network, and a second capacitor connected with the second resistor in parallel;
a first signal of a differential input signal enters the positive input port of the first feedforward amplifier, and a second signal of the differential input signal enters the positive input port of the second feedforward amplifier;
the analog front-end circuit for the bioelectric sensor further includes a common-mode leakage current compensation circuit provided with an error amplifier, a leakage current compensator and an output common-mode voltage detector:
   the output common-mode voltage detector detects the voltage at the respective output ports of the first feedforward amplifier and the second feedforward amplifier to generate common-mode voltage thereof;
   ports of the error amplifier include a positive input port, a negative input port and an output port, and the common-mode voltage generated by the output common-mode voltage detector enters the positive input port of the error amplifier; the common-mode voltage of the differential input signal enters the negative input port of the error amplifier, and the output port of the error amplifier generates the control voltage of the leakage current compensator;
   ports of the leakage current compensator include a control voltage input port and two compensation current output ports, and the two compensation current output ports generate compensation current to respectively offset the leakage current of the negative input ports of the first feedforward amplifier and the second feedforward amplifier;
   the output common-mode voltage detector is provided with a symmetrical voltage divider, and the voltage divider includes a first impedance network and a second impedance network symmetrical to each other; the first impedance network includes a third resistor and a third capacitor connected with the third resistor in parallel, and the second impedance network includes a fourth resistor and a fourth capacitor connected with the fourth resistor in parallel;
   the leakage current compensator includes a fifth resistor and a sixth resistor symmetrical to each other;
   one end of the fifth resistor acts as one of the compensation current output ports and is connected with the negative input port of the first feedforward amplifier; one end of the sixth resistor acts as another compensation current output port and is connected with the negative input port of the second feedforward amplifier;
   the other ends of the fifth resistor and the sixth resistor are connected as the control voltage input port which is connected with the output port of the error amplifier to connect the control voltage output to the leakage current compensator.

Exemplarily, the analog front-end circuit for the bioelectric sensor is further provided with a fifth capacitor and a sixth capacitor symmetrical to each other; one end of the fifth capacitor is connected with the negative input port of the first feedforward amplifier, and one end of the sixth capacitor is connected with the negative input port of the second feedforward amplifier; the other ends of the fifth capacitor and the sixth capacitor are connected to connect the common-mode voltage of the differential input signal or the control voltage output to the leakage current compensator.

Exemplarily, the common-mode voltage of the differential input signal is detected by a seventh resistor and an eighth resistor symmetrical to each other; one end of the seventh resistor is connected with the positive input port of the first feedforward amplifier, one end of the eighth resistor is connected with the positive input port of the second feedforward amplifier, and the other ends of the seventh resistor and the eighth resistor are connected to output the common-mode voltage detected from the differential input signal.

Exemplarily, the first resistor, the second resistor, the third resistor, the fourth resistor, the fifth resistor, the sixth resistor, the seventh resistor and the eighth resistor are respectively implemented by devices or structures equivalent to resistor functions.

Another technical solution of the present application provides an analog front-end circuit for a bioelectric sensor, wherein the analog front-end circuit for the bioelectric sensor includes:
a first feedforward amplifier, a first resistor and a first capacitor connected with the first resistor in parallel being provided between an output port and a negative input port of the first feedforward amplifier, a positive input port of the first feedforward amplifier being connected with a first signal of a differential input signal;
a second feedforward amplifier, a second resistor and a second capacitor connected with the second resistor in parallel being provided between an output port and a negative input port of the second feedforward amplifier, a positive input port of the second feedforward amplifier being connected with a second signal of the differential input signal, the first feedforward amplifier and the second feedforward amplifier being symmetrical to each other, the first resistor and the second resistor having the same parameters, the first capacitor and the second capacitor having the same parameters;
a third resistor and a fourth resistor having the same parameters, one end of the third resistor being connected with an output port of the first feedforward amplifier, one end of the fourth resistor being connected with an output port of the second feedforward amplifier, the other ends of the third resistor and the fourth resistor being connected to generate output common-mode voltage, the output common-mode voltage corresponding to the common-mode voltage of the output voltage of the first feedforward amplifier and the output voltage of the second feedforward amplifier;
an error amplifier, a positive input port of the error amplifier being connected with the output common-mode voltage, a negative input port of the error amplifier being connected with the common-mode signal, an output port of the error amplifier generating control voltage;
a fifth resistor and a sixth resistor having the same parameters, one ends of the fifth resistor and the sixth resistor being connected to connect the control voltage output by the error amplifier, the other end of the fifth resistor being connected with the negative input port of the first feedforward amplifier and outputting compensation current to offset the leakage current of the negative input port of the first feedforward amplifier, the other end of the sixth resistor being connected with the negative input port of the second feedforward amplifier and outputting compensation current to offset the leakage current of the negative input port of the second feedforward amplifier.

Exemplarily, the analog front-end circuit for the bioelectric sensor further includes a fifth capacitor and a sixth capacitor having the same parameters; one end of the fifth capacitor is connected with the negative input port of the first feedforward amplifier, and one end of the sixth capacitor is connected with the negative input port of the second feedforward amplifier; the other ends of the fifth capacitor and the sixth capacitor are connected to connect the common-mode voltage of the differential input signal or the control voltage generated by the error amplifier.

Exemplarily, the third resistor is connected with a third capacitor in parallel; the fourth resistor is connected with a fourth capacitor in parallel; the third capacitor and the fourth capacitor have the same parameters.

Exemplarily, the common-mode signal connected with the negative input port of the error amplifier is fixed nominal common-mode voltage; or the common-mode signal is the common-mode voltage of the differential input signal.

Exemplarily, when the common-mode signal is the common-mode voltage of the differential input signal, the analog front-end circuit for the bioelectric sensor further includes a seventh resistor and an eighth resistor symmetrical to each other;
one end of the seventh resistor is connected with the positive input port of the first feedforward amplifier, one end of the eighth resistor is connected with the positive input port of the second feedforward amplifier, and the other ends of the seventh resistor and the eighth resistor are connected to output the common-mode voltage of the differential input signal.

Exemplarily, the first resistor, the second resistor, the third resistor, the fourth resistor, the fifth resistor, the sixth resistor, the seventh resistor and the eighth resistor are respectively implemented by devices or structures equivalent to resistor functions.

Exemplarily, the devices or structures equivalent to resistor functions include pseudo-resistors.

Exemplarily, each pseudo-resistor includes an equivalent resistor structure based on PMOS transistors, or is formed by connecting a plurality of equivalent resistor structures based on PMOS transistors in series; each equivalent resistor structure based on PMOS transistors is formed by back to back connecting PMOS devices connected by two diodes.

The present application provides a novel analog front-end circuit, which has the following advantages:
(1) It can not only suppress the reverse bias leakage current of the parasitic diode of the pseudo-resistor, but also suppress the common-mode components of the leakage current of various mechanisms such as the gate leakage current of the feedforward amplifier.
(2) It has stable compensation performance under different MOS processes, capacitor processes, power supply voltages and temperatures.
(3) The input common-mode range is wide, so that it only needs to ensure that the leakage current compensator provides sufficient compensation current under different conditions.
(4) All the devices in the circuit can be realized by adopting the common single N-well CMOS process, thus avoiding the requirement of the special process.
(5) The cost of circuit area and power consumption is low, and the error amplifier with small bandwidth can be designed.
(6) The bridged capacitor of the impedance network can adjust the loop stability under the AC simulation of the common-mode signal.
(7) By improving the resistor and capacitor structure of the output port of the error amplifier, the loop stability under the AC simulation of the common-mode signal and the AC characteristics of the control voltage at the output end of the error amplifier are greatly improved.

### Description of the Drawings

FIG. 1 illustrates al schematic diagram of a structure of a classical instrument amplifier.
FIG. 2 illustrates a schematic diagram of an improved structure of an existing instrument amplifier in the bioelectric field.
FIG. 3 and FIG. 3a illustrate two pseudo-resistor circuits based on MOS.
FIG. 4 illustrates a sectional diagram of an MOS device connected by diodes.
FIG. 5 illustrates a schematic diagram of influences of bias voltage on equivalent resistance when a pseudo-resistor is used.
FIG. 6 is a schematic diagram of an existing analog front-end leakage current compensation circuit.
FIG. 7 illustrates a circuit for simulation of NM1 and NM2 connection modes in FIG. 6.
FIG. 8 illustrates a schematic diagram of simulation of a circuit in FIG. 7 to indicate a relationship between gate current and control voltage of an NMOS transistor.
FIG. 9 illustrates a schematic diagram of simulation of a circuit in FIG. 6 to indicate a relationship between leakage current and differential output voltage.
FIG. 10 illustrates a schematic diagram of an analog front-end circuit for a bioelectric sensor provided by the present application.
FIG. 11 illustrates a schematic diagram of a circuit according to embodiment 1 of the present application.
FIG. 12 illustrates a schematic diagram of simulation of a circuit in FIG. 11 to indicate a relationship between leakage current and differential output voltage.
FIG. 13 illustrates a schematic diagram of simulation of a circuit in FIG. 11 to indicate a relationship among gain, phase and frequency.
FIG. 14 illustrates a schematic diagram of simulation of a circuit in FIG. 11 after a capacitor connected with an output detection resistor in parallel is removed to indicate a relationship among gain, phase and frequency. Comparison between FIG. 13 and FIG. 14 is used to reflect a low-pass filtering effect after a parallel capacitor is integrated.
FIG. 15 and FIG. 15a respectively illustrate schematic diagrams of circuits according to embodiment 2 and embodiment 3 of the present application. A resistor and capacitor structure at an output port of an error amplifier is improved. Common-mode signals connected to OTA negative input ports are different in the two embodiments.
FIG. 16 illustrates a schematic diagram of simulation of a circuit in FIG. 15a after a capacitor connected with an output detection resistor in parallel is removed to indicate a relationship among gain, phase and frequency.
FIG. 17 illustrates a schematic diagram of simulation of a circuit in FIG. 15a to indicate a relationship among gain, phase and frequency. Comparison between FIG. 16 and FIG. 17 is used to reflect a low-pass filtering effect after a parallel capacitor is integrated.
FIG. 18 illustrates a schematic diagram of simulation of a circuit in FIG. 11 to indicate control voltage gain.

### Description of the Embodiments

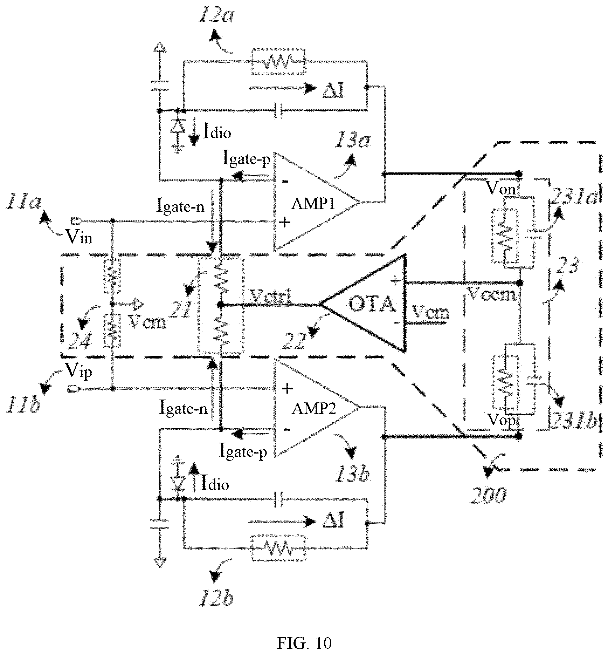

The present application provides an analog front-end circuit for a bioelectric sensor. Referring to FIG. 10, the analog front-end circuit for the bioelectric sensor includes a first feedforward amplifier 13a, a first feedback network 12a, a second feedforward amplifier 13b and a second feedback network 12b.

Ports of the first feedforward amplifier 13a include a positive input port, a negative input port and an output port; ports of the second feedforward amplifier 13b include a positive input port, a negative input port and an output port; an input end of the first feedback network 12a is the output port of the first feedforward amplifier 13a, an output end of the first feedback network 12a is the negative input port of the first feedforward amplifier 13a, and the first feedback network 12a includes a resistor bridged from the input end of the first feedback network 12a to the output end of the first feedback network 12a; an input end of the second feedback network 12b is the output port of the second feedforward amplifier 13b, an output end is the negative input port of the second feedforward amplifier 13b, and the second feedback network 12b includes a resistor bridged from the input end of the second feedback network 12b to the output end of the second feedback network 12b; a differential input signal includes a first signal 11a and a second signal 11b, the first signal 11a enters the positive input port of the first feedforward amplifier 13a, and a second signal 11b enters the positive input port of the second feedforward amplifier 13b; the first feedforward amplifier 13a and the second feedforward amplifier 13b are symmetrical to each other; the first feedback network 12a and the second feedback network 12b are symmetrical to each other.

A common-mode leakage current compensation circuit 200 of the analog front-end includes an error amplifier 22, a leakage current compensator 21 and an output common-mode voltage detector 23.

The output common-mode voltage detector 23 detects the voltage Von and Vop at the respective output ports of the first feedforward amplifier 13a and the second feedforward amplifier 13b to generate common-mode voltage thereof, which is called output common-mode voltage Vocm.

Ports of the error amplifier 22 include a positive input port, a negative input port and an output port, and the output (corresponding to the output common-mode voltage Vocm) of the output common-mode voltage detector 23 enters the positive input port of the error amplifier 22, the common-mode voltage 24 (called as input common-mode voltage Vcm) of the differential input signal enters the negative input port of the error amplifier 22, and the output port of the error amplifier 22 generates the control voltage Vctrl of the leakage current compensator 21.
ports of the leakage current compensator 21 include a control voltage input port and two compensation current output ports; the two compensation current output ports generate compensation current I_{gate-n} to respectively offset the leakage current of the negative input ports of the first feedforward amplifier 13a and the second feedforward amplifier 13b.

The output common-mode voltage detector 23 is a symmetrical voltage divider, which includes a first impedance network 231a and a second impedance network 231b; the first impedance network 231a and the second impedance network 231b are symmetrical to each other, and respectively include resistors or devices and structures equivalent to resistor functions.

The common-mode voltage 24 (corresponding to the input common-mode voltage Vcm) of the differential input signal is detected by two symmetrical resistors or devices and structures equivalent to resistor functions.

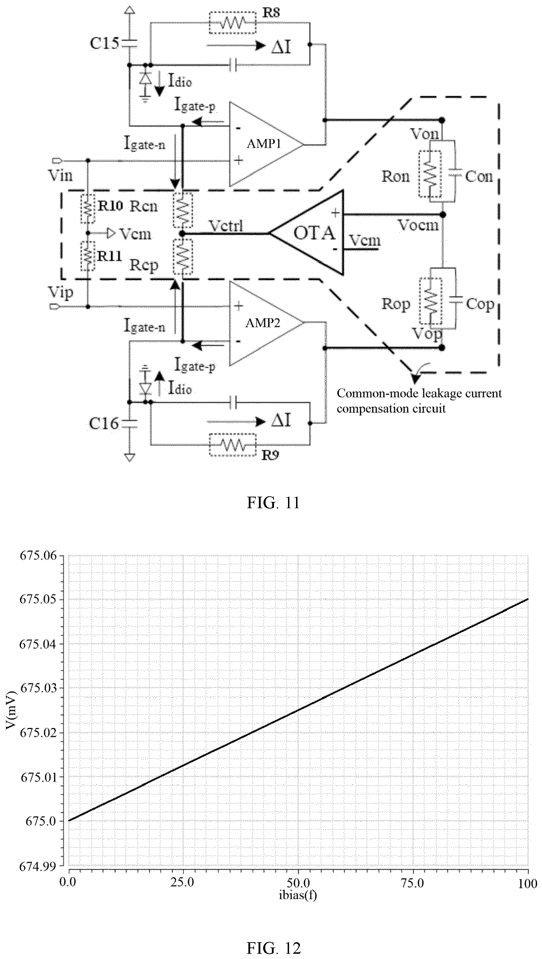

In one embodiment illustrated in FIG. 11, an impedance voltage divider used as the output common-mode voltage detector includes a resistor Ron, a resistor Rop, a capacitor Con, and a capacitor Cop. Ron and Rop have the same parameters, and Con and Cop have the same parameters. One ends of the parallel resistor Ron and capacitor Con are connected with the output port of the feedforward amplifier AMP1, and one ends of the parallel resistor Rop and capacitor Cop are connected with the output port of the feedforward amplifier AMP2. The other ends of Ron, Rop, Con and Cop are connected and further connected to the positive input port of the error amplifier. The impedance voltage divider can detect the common-mode voltage that generates the output voltages Von and Vop of the two feedforward amplifiers, that is, the output common-mode voltage Vocm, and has a low-pass filtering effect on the differential output signal of the analog front-end.

In this embodiment, an Operational Transconductance Amplifier (OTA) is used as the error amplifier, which needs to be effective within the frequency band of the input common-mode voltage signal. The positive input port of the OTA is connected with the output common-mode voltage Vocm, the negative input port is connected with the input common-mode voltage Vcm, and the output port generates the control voltage Vctrl of the leakage current compensator.

In this embodiment, the leakage current compensator includes a resistor Rcn and a resistor Rcp. Rcn and Rcp have the same parameters. One end of Rcn is connected with the negative input port of the feedforward amplifier AMP1. One end of Rcp is connected with the negative input port of the feedforward amplifier AMP2. The other ends of Rcn and Rcp are connected with each other, and are connected with the output port of the error amplifier to connect the control voltage Vctrl output by the error amplifier.

A resistance voltage divider is provided and includes resistors R10 and R11. One end of R10 is connected with the positive input port of the feedforward amplifier AMP1. One end of R11 is connected with the positive input port of the feedforward amplifier AMP2. The other ends of R10 and R11 are connected with each other. The input common-mode voltage Vcm can be detected from the first signal Vin and the second signal Vip of the differential input signal. The input common-mode voltage Vcm is connected with the negative input port of the error amplifier.

Capacitors C15 and C16 are further provided. One end of C15 is connected with the negative input port of the feedforward amplifier AMP1. One end of C16 is connected with the negative input port of the feedforward amplifier AMP2. The other ends of C15 and C16 are connected with the input common-mode voltage Vcm detected by the resistance voltage divider.

In the above example, the bridging resistors R8 and R9 of the feedback network, the resistors Ron and Rop of the impedance voltage divider, the resistors Rcn and Rcp of the leakage current compensator, and the resistors R10 and R11 of the resistance voltage divider may all be implemented by using common resistor devices, or by using pseudo-resistors or other technologies equivalent to resistors, but their respective resistance or equivalent resistance can be set according to application requirements and simulation effects.

The resistance of the resistor device or the equivalent resistance of the pseudo-resistor can reach the range of hundreds of megaohms (MΩ) to gigaohms (GΩ), or reach the level of teraohm (TΩ). Of course, it can also be designed in a small resistance range, which is not limited in the present application.

A way to design pseudo-resistors based on MOS devices is to back to back connect PMOS devices connected by diodes (as illustrated in FIG. 3 or FIG. 3a). Alternatively, many stages of back-to-back PMOS structures may be connected in series to form a pseudo-resistor to further increase the linear range and linearity.

The analog front-end circuit illustrated in FIG. 10 and FIG. 11 can not only eliminate the common-mode leakage current through the common-mode leakage current compensation circuit, but also perform low-pass filtering to the amplified signal, and can withstand the dynamic change of the input common-mode voltage.

Specifically, through the negative feedback loop, the compensation current output by the leakage current compensator (corresponding to Rcn and Rcp) is I_{gate-n} = I_{gate-p}-I_{dio}, so as to eliminate the common-mode leakage current. I_{gate-p} represents the leakage current of the differential input signal to the gate of the MOS device in the feedforward amplifier; I_{dio} represents the leakage current of the pseudo-resistor based on MOS in the feedback network.

By dividing the voltage through the impedance network, based on the bridged capacitor in the impedance network (corresponding to Con and Cop), the following effect can be further produced:
a) A low-pass filtering effect on the differential output signal is produced: since bioelectric signals collected by biosensors, such as ECG (electrocardiogram) and EEG (electroencephalogram), have a low upper bandwidth limit (such as 40Hz or 150Hz), low-pass filtering can ensure the upper bandwidth limit of the differential output signal, so as to suppress high-frequency clutter or noise signals. In this solution, through the bridged capacitor in the impedance network, rough filtering can be realized in the signal link in advance, so as to enhance the overall low-pass filtering effect, or relax the requirements of the subsequent low-pass filtering and reduce the power consumption and complexity of the system.
b) The loop stability under the AC simulation of the common-mode signal is adjusted: the actual simulation modeling shows that if the voltage is divided only by large resistors, the feedback loop may oscillate due to insufficient phase margin at high frequency; if the bridged capacitor is added, the phase margin of the feedback loop can be adjusted to maintain its stability at high frequency.

The following describes the leakage current compensation effect of this embodiment through simulation. The circuit in FIG. 11 is simulated by using the opamp of veriloga as the feedforward amplifier and adopting the basic resistor and capacitor models res and cap. Exemplarily, the bridged resistors R8 and R9 of the feedback network are set to 1TΩ, and are respectively connected with 3pF capacitors in parallel. The resistors Rcn and Rcp of the leakage current compensator are set to IT Ω, and the capacitors C15 and C16 are set to 30pf. The resistors R10 and R11 of the resistance voltage divider are set to 1GΩ. The resistors Ron and Rop of the impedance voltage divider are set to 1GΩ, and are respectively connected with 72pF filter capacitors in parallel. When the differential input signal is set to 675mV DC, the input leakage current parameter i_{bias} of opamp is changed to perform DC scanning and observe the voltage at the two differential output ends.

According to the simulation results in FIG. 12, the differential output voltage increases linearly, but almost remains at 675mV close to the input DC signal. When the input leakage current of opamp is 100fA, the differential output voltage is about 675.05mV. In combination with the resistance value of the bridged resistor which is 1TΩ, the leakage current flowing through the bridged resistor is about 0.05fA. Therefore, the leakage current is reduced by 99.95% through this circuit.

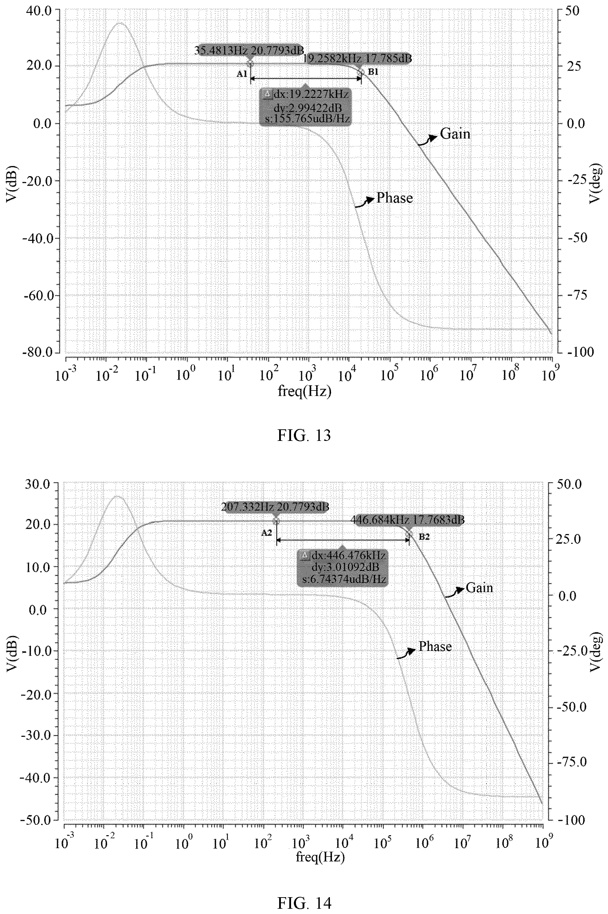

Further, the low-pass filtering effect of the output detection parallel capacitor is confirmed by simulation. When the circuit is adopted, the differential input signal is respectively added with +0.5V and -0.5V AC signals for frequency domain scanning. According to FIG. 13, the -3dB low-pass cutoff frequency is about 19kHz (point A1 corresponds to 35.481Hz and 20.7793dB, and point B1 corresponds to 19.2582kHz and 17.785dB; the difference dx between the two points is 19.2227kHz, dy is 2.99422dB, and the slope s is 155.765udB/Hz). As a comparison, the parallel capacitors on Ron and Rop are removed for simulation. According to FIG. 14, when other parameters remain unchanged, the -3dB low-pass cutoff frequency is about 467kHz (point A2 corresponds to 207.332Hz and 20.7793dB, and point B2 corresponds to 446.684kHz and 17.785dB; the difference dx between the two points is 446.476kHz, dy is 3.01092dB, s is 6.74374udB/Hz), indicating that the parallel capacitors have a low-pass filtering effect on the differential signal.

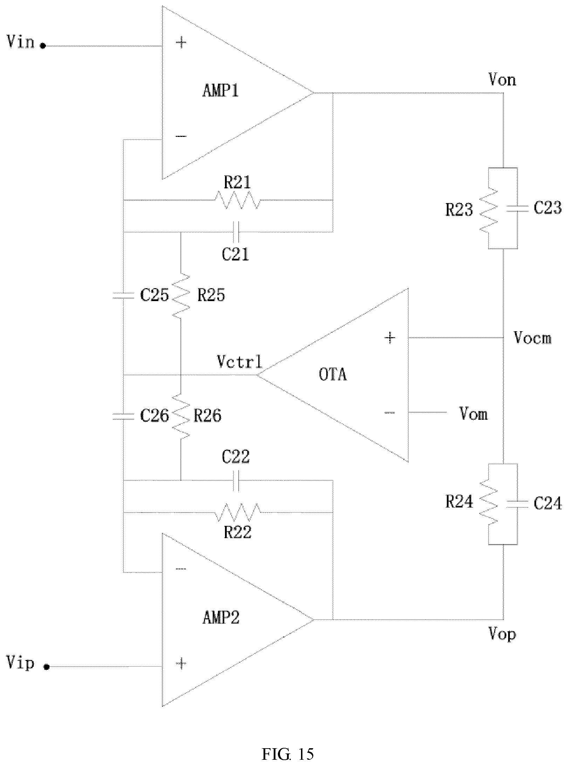

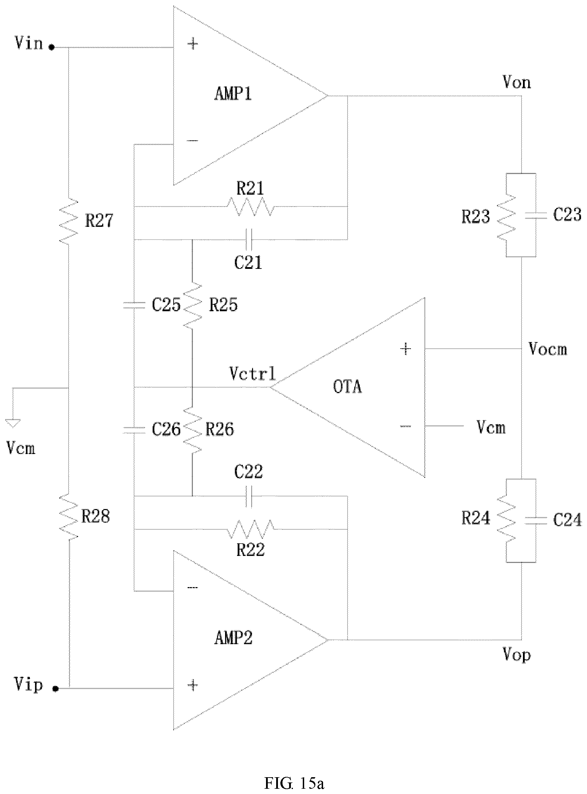

In the embodiment of an analog front-end circuit illustrated in FIG. 15, the first signal Vin and the second signal Vip of the differential input signal are respectively connected with the positive input ports of the feedforward amplifiers AMP1 and AMP2. The feedforward amplifiers MP1 and AMP2 have corresponding feedback networks, including a capacitor C21 between the output port and the negative input port of the feedforward amplifier AMP1, a bridged resistor R21 connected with the capacitor C21 in parallel, a capacitor C22 between the output port and the negative input port of the feedforward amplifier AMP2 and a bridged resistor R22 connected the capacitor C22 in parallel. The two feedforward amplifiers are symmetrical to each other, and their feedback networks are symmetrical to each other.

The output common-mode voltage detector includes a detection resistor and a capacitor connected with the detection resistor in parallel, and is used to detect the DC and AC output common-mode voltages. That is, an impedance voltage divider is formed through a resistor R23, a resistor R24, a capacitor C23 and a capacitor C24. R23 and R24 have the same parameters, and C23 and C24 have the same parameters. One ends of the parallel resistor R23 and capacitor C23 are connected with the output port of the feedforward amplifier AMP1. One ends of the parallel resistor R24 and capacitor C24 are connected with the output port of the feedforward amplifier AMP2. The other ends of R23, R24, C23 and C24 are respectively connected with each other and are further connected to the positive input port of the error amplifier. The impedance voltage divider can detect the common-mode voltage that generates the output voltages Von and Vop of the two feedforward amplifiers, that is, the output common-mode voltage Vocm, and has a low-pass filtering effect on the differential output signal of the analog front-end.

As the error amplifier, an OTA may be used (it needs to be effective within the frequency band of the input common-mode voltage signal). The positive input port of the OTA is connected with the output common-mode voltage Vocm, the negative input port is connected with the fixed nominal common-mode voltage Vom, and the output port generates the control voltage Vctrl of the leakage current compensator.

The leakage current compensator includes a resistor R25 and a resistor R26. R25 and R26 have the same parameters. One end of R25 is connected with the negative input port of the feedforward amplifier AMP1. One end of R26 is connected with the negative input port of the feedforward amplifier AMP2. The other ends of R25 and R26 are connected with each other and are connected with the output port of the error amplifier to connect the control voltage Vctrl output by the error amplifier.

One end of the capacitor C25 is connected with the negative input port of the feedforward amplifier AMP1. One end of C26 is connected with the negative input port of the feedforward amplifier AMP2. The other ends of C25 and C26 are connected with each other and are connected with a connection point of the resistors R25 and R26 of the leakage current compensator to connect the control voltage Vctrl output by the error amplifier.

Another embodiment illustrated in FIG. 15A is mostly the same as the circuit illustrated in FIG. 15, which includes two feedforward amplifiers and their feedback networks, an output common-mode voltage detector, an error amplifier and a leakage current compensator. The main difference is that the common-mode signal connected with the negative input port of the error amplifier is different.

In this embodiment, resistors R21 and R22 and capacitors C21 and C22 bridged at the symmetrical two feedforward amplifiers AMP1 and AMP2 can provide high-pass zero poles under differential amplification, and together with the resistor and capacitor structure of the output port of the error amplifier (such as OTA), provide the multiple of differential amplification. It affects the polarity and stability of the negative feedback loop of the common-mode signal.

The output common-mode detector can detect the DC and AC output common-mode voltages. Capacitors C23 and C24 connected with detection resistors R23 and R24 in parallel can adjust the stability of the common-mode loop and integrate low-pass filtering.

In this embodiment, a resistance voltage divider is provided and includes resistors R27 and R28. One end of the resistor R27 is connected with the positive input port of the feedforward amplifier AMP1. The other ends of R27 and R28 are connected with the positive input port of the feedforward amplifier AMP2. The input common-mode voltage Vcm can be detected from the first signal Vin and the second signal Vip of the differential input signal. The input common-mode voltage Vcm is connected to the negative input port of the error amplifier.

The error amplifier (such as OTA) uses negative feedback to generate DC bias voltage at its output port, compensate DC common-mode leakage current, and clamp the output common-mode voltage Vocm to the input common-mode voltage Vcm at the negative input port of the OTA. Moreover, through negative feedback, appropriate AC bias voltage is generated at the output port of the OTA, and a stable common-mode feedback loop is provided. Under the action of the differential signal, both the output port and the negative input port of the OTA provide stable intermediate-level voltage, so that differential-mode amplification is not affected by the leakage current and common-mode signal.

The resistor and capacitor structure of the output port of the OTA compensates DC common-mode leakage current through resistors R25 and R26. The parallel capacitors C25 and C26 with large multiples can provide differential-mode amplification multiples. The parallel capacitors C25 and C26 can also make the AC voltage at the output port of the OTA not swing too greatly in the negative feedback loop.

In the examples illustrated in FIG. 15 and FIG. 15a, the bridged resistors R21 and R22 of the feedback network, the resistors R23 and R24 of the impedance voltage divider, the resistors R25 and R26 of the leakage current compensator, and the resistors R27 and R28 of the resistance voltage divider may all be implemented by using common resistor devices, or by using pseudo-resistors or other technologies equivalent to pseudo-resistors, but their respective resistance or equivalent resistance can be set according to application requirements and simulation effects.

The equivalent resistance of the resistor device or pseudo-resistor can reach the range of hundreds of megaohms (MΩ) to gigaohms (GΩ), or reach the level of teraohm (TΩ). Of course, it can also be designed in a small resistance range, which is not limited in the present application.

A way to design pseudo-resistors based on MOS devices is to back to back connect PMOS devices connected by diodes (as illustrated in FIG. 3 or FIG. 3a). Alternatively, many stages of back-to-back PMOS structures may be connected in series to form a pseudo-resistor to further increase the linear range and linearity.

Comparing the examples in FIG. 15 and FIG. 15a, it can be seen that there are two configurations for the common-mode signal connected with the negative input port of the OTA:
Firstly, a fixed nominal common-mode voltage VOM can be connected (FIG. 15), so that even if there is a large common-mode input signal, the output common-mode voltage will be clamped to this nominal voltage, greatly improving the overall common-mode suppression capability of the instrument amplifier.

Secondly, the common-mode input signal Vcm (FIG. 15a) from R27 and R28 may be connected, so that the common-mode input signal is followed in the form of unit gain, the amplification of the differential signal is not affected, the overall common-mode suppression is improved, and the common-mode leakage can be effectively eliminated.

For the above two configurations, the following conditions shall be met when selecting component parameters:
1) The common-mode negative feedback loop is stable; 2) the voltage at each node, such as the output port of the OTA, the positive input port of the OTA and the differential output end of the instrument amplifier, has normal amplitude under the action of common-mode signal or differential-mode signal, which can effectively amplify the differential-mode (differential) signal and suppress the common-mode signal.

The working principles of the above two configurations are similar. The reason for the different effects is that the negative input port of the OTA is connected with the fixed-level nominal common-mode voltage Vom or the common-mode input signal Vcm of the voltage division output, which will make the input reference potential of the common-mode negative feedback loop different and then the AC response of each node on the loop different. Finally, the common-mode rejection ratio is caused to be different (the common-mode rejection ratio when connected with the fixed level is better than that when connected with the common-mode input signal of the voltage division output).

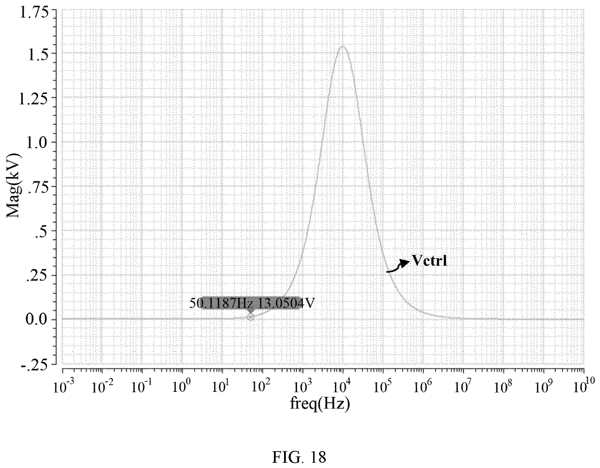

Then the example in FIG. 11 is compared with that in FIG. 15A. In the solution in FIG. 11, for the capacitors (corresponding to C15 and C16) provided in cooperation with the leakage current compensation resistors (corresponding to Rcn and Rcp), their common connected end is connected with the input common-mode voltage Vcm, which may cause the problem that the AC amplitude of the control voltage at the output end of the error amplifier OTA is too large. As can be seen from the simulation results in FIG. 18, in an example of the solution illustrated in FIG. 11, compared with the input common-mode voltage, the control voltage will have a gain of nearly 1500 times and a gain of nearly 13 times at 50Hz. It will lead to distortion or saturation because the control voltage swings too greatly during actual work. Under large 50Hz mains supply interference, this means that the common-mode suppression effect is greatly reduced.

The embodiment illustrated in FIG. 15a, as a novel analog front-end circuit for a bioelectric sensor, can effectively eliminate a variety of common-mode leakage currents. The DC simulation proves that it can eliminate the common-mode leakage current, and the loop stability problem will not occur under the AC simulation of the common-mode signal through appropriate parameter selection. The capacitors (corresponding to C23 and C24) connected with the resistors in parallel at the positive input port of the OTA and the capacitors (corresponding to C25 and C26) connected with the resistors in parallel at the output port of the OTA can further adjust the stability of the common-mode loop (the capacitors connected with the resistors at the positive input port of the OTA further has the functions of realizing low-pass filtering and enhancing the effect of partial voltage extraction to output the common-mode voltage).

Exemplarily, when the analog front-end circuit illustrated in FIG. 15a is applied to a typical application scenario of bioelectric signal detection, the signal bandwidth is as low as 0.05Hz, that is, the amplification detection circuit requires a high-pass filtering function with cutoff frequency of 0.05Hz.

The circuit in FIG. 15a is simulated by using the opamp of veriloga as the feedforward amplifier and the basic resistor and capacitor models res and cap. Exemplarily, the bridged resistors R21 and R22 of the feedback network are set to 1TΩ, and the parallel bridged capacitors C21 and C22 are respectively 1 time of unit capacitance (3pF), the resistors R25 and R26 jointly forming the high-pass zero-pole leakage current compensator are set to 1TΩ, and the resistors R23 and R24 of the impedance voltage divider are set to 1.5GQ. If a resistance voltage divider is set, its resistors R27 and R28 can be set to 1.5GQ. The capacitance of other capacitors may be integral times of unit capacitance. For example, the capacitors C25, C26, C27 and C28 are respectively set to 3pf.

When the differential input signal is set to 675mV DC, the input leakage current parameter i_{bias} of opamp is changed to perform DC scanning and observe the voltage at the two differential output ends. Then, the example in FIG. 15a has the basically same leakage current compensation effect as the example in FIG. 11. In addition, the circuit connection mode illustrated in FIG. 15a can further greatly improve the loop stability under common-mode signal AC simulation and the AC characteristics of the control voltage at the output end of the error amplifier OTA.

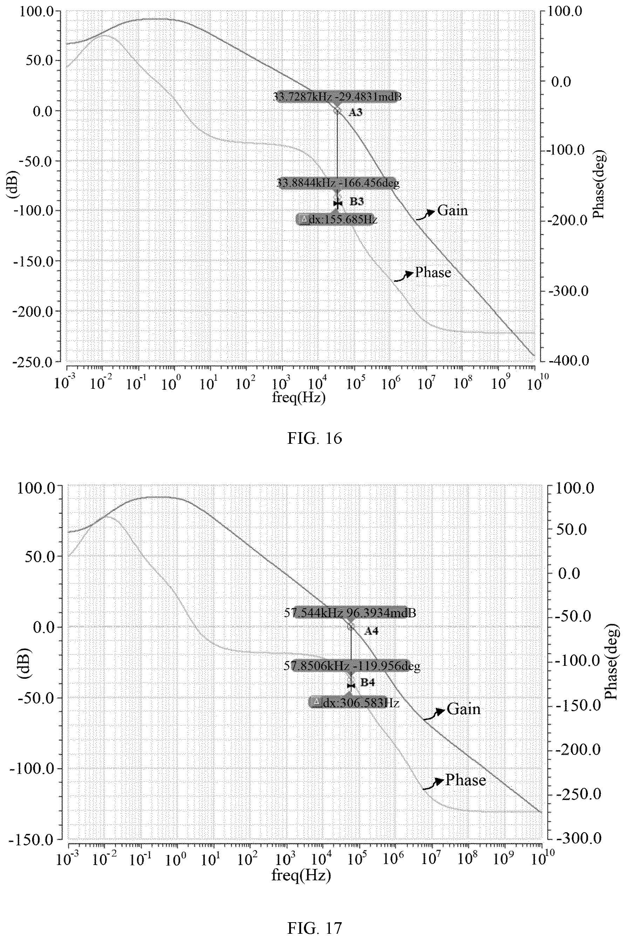

Specifically, if the capacitors C23 and C24 connected with the output detection resistors (corresponding to R23 and R24) in parallel in the solution illustrated in FIG. 15a are removed, the problem of insufficient stability of the common-mode signal loop may occur. According to the simulation results illustrated in FIG. 16, in the solution in which C23 and C24 are removed, at -29.4831mdB, point A3 corresponds to 33.728kHz, point B3 corresponds to 33.8844kHz, and the difference dx between the two is 15.685Hz. When the gain drops to 0dB, the phase shift is nearly -166°, and the phase margin is only 14°, which is not enough compared with the minimum value of 30° required by the phase margin, and it is likely to cause the loop to oscillate under the excitation of high-frequency signals.

In contrast, if the solution illustrated in FIG. 15a is adopted, the stability of the common-mode signal loop will be greatly improved. According to the simulation results illustrated in FIG. 17, in the solution in which capacitors C23 and C24 are provided, at 96.3934mdB, point A4 corresponds to 57.544kHz, point B4 corresponds to 57.8506kHz, and the difference dx between the two is 306.583Hz. When the gain drops to 0dB, the phase shift is nearly -120°, and the phase margin is 60°, which meets the requirement that the loop is fully stable.

Although the content of the present application has been described in detail by the above preferred embodiments, it should be recognized that the above description should not be considered as a limitation to the present application. After those skilled in the art have read the above content, various modifications and substitutions of the present application will be obvious. Therefore, the scope of protection of the present application should be defined by the appended claims.

## Claims

1. An analog front-end circuit for a bioelectric sensor, comprising a first feedforward amplifier, a first feedback network, a second feedforward amplifier and a second feedback network, wherein the first feedforward amplifier and the second feedforward amplifier are symmetrical to each other; the first feedback network and the second feedback network are symmetrical to each other;
ports of the first feedforward amplifier comprise a positive input port, a negative input port and an output port; ports of the second feedforward amplifier comprise a positive input port, a negative input port and an output port;
an input end of the first feedback network is the output port of the first feedforward amplifier, an output end of the first feedback network is the negative input port of the first feedforward amplifier, and the first feedback network comprises a first resistor bridged from the input end of the first feedback network to the output end of the first feedback network, and a first capacitor connected with the first resistor in parallel;
an input end of the second feedback network is the output port of the second feedforward amplifier, an output end is the negative input port of the second feedforward amplifier, and the second feedback network comprises a second resistor bridged from the input end of the second feedback network to the output end of the second feedback network, and a second capacitor connected with the second resistor in parallel;
a first signal of a differential input signal enters the positive input port of the first feedforward amplifier, and a second signal of the differential input signal enters the positive input port of the second feedforward amplifier;
the analog front-end circuit for the bioelectric sensor further comprises a common-mode leakage current compensation circuit provided with an error amplifier, a leakage current compensator and an output common-mode voltage detector:
the output common-mode voltage detector detects the voltage at the respective output ports of the first feedforward amplifier and the second feedforward amplifier to generate common-mode voltage thereof;
ports of the error amplifier comprise a positive input port, a negative input port and an output port, and the common-mode voltage generated by the output common-mode voltage detector enters the positive input port of the error amplifier; the common-mode voltage of the differential input signal enters the negative input port of the error amplifier, and the output port of the error amplifier generates the control voltage of the leakage current compensator;
ports of the leakage current compensator comprise a control voltage input port and two compensation current output ports, and the two compensation current output ports generate compensation current to respectively offset the leakage current of the negative input ports of the first feedforward amplifier and the second feedforward amplifier;
the output common-mode voltage detector is provided with a symmetrical voltage divider, and the voltage divider comprises a first impedance network and a second impedance network symmetrical to each other; the first impedance network comprises a third resistor and a third capacitor connected with the third resistor in parallel, and
the second impedance network comprises a fourth resistor and a fourth capacitor connected with the fourth resistor in parallel;
the leakage current compensator comprises a fifth resistor and a sixth resistor symmetrical to each other;
one end of the fifth resistor acts as one of the compensation current output ports and is connected with the negative input port of the first feedforward amplifier; one end of the sixth resistor acts as another compensation current output port and is connected with the negative input port of the second feedforward amplifier;
the other ends of the fifth resistor and the sixth resistor are connected as the control voltage input port which is connected with the output port of the error amplifier to connect the control voltage output to the leakage current compensator.

2. The analog front-end circuit for the bioelectric sensor according to claim 1, wherein
the analog front-end circuit for the bioelectric sensor is further provided with a fifth capacitor and a sixth capacitor symmetrical to each other; one end of the fifth capacitor is connected with the negative input port of the first feedforward amplifier, and one end of the sixth capacitor is connected with the negative input port of the second feedforward amplifier; the other ends of the fifth capacitor and the sixth capacitor are connected to connect the common-mode voltage of the differential input signal or the control voltage output to the leakage current compensator;
the common-mode voltage of the differential input signal is detected by a seventh resistor and an eighth resistor symmetrical to each other; one end of the seventh resistor is connected with the positive input port of the first feedforward amplifier, one end of the eighth resistor is connected with the positive input port of the second feedforward amplifier, and the other ends of the seventh resistor and the eighth resistor are connected to output the common-mode voltage detected from the differential input signal;
the first resistor, the second resistor, the third resistor, the fourth resistor, the fifth resistor, the sixth resistor, the seventh resistor and the eighth resistor are respectively implemented by devices or structures equivalent to resistor functions.

3. An analog front-end circuit for a bioelectric sensor, wherein the analog front-end circuit for the bioelectric sensor comprises:
a first feedforward amplifier, a first resistor and a first capacitor connected with the first resistor in parallel being provided between an output port and a negative input port of the first feedforward amplifier, a positive input port of the first feedforward amplifier being connected with a first signal of a differential input signal;
a second feedforward amplifier, a second resistor and a second capacitor connected with the second resistor in parallel being provided between an output port and a negative input port of the second feedforward amplifier, a positive input port of the second feedforward amplifier being connected with a second signal of the differential input signal, the first feedforward amplifier and the second feedforward amplifier being symmetrical to each other, the first resistor and the second resistor having the same parameters, the first capacitor and the second capacitor having the same parameters;
a third resistor and a fourth resistor having the same parameters, one end of the third resistor being connected with an output port of the first feedforward amplifier, one end of the fourth resistor being connected with an output port of the second feedforward amplifier, the other ends of the third resistor and the fourth resistor being connected to generate output common-mode voltage, the output common-mode voltage corresponding to the common-mode voltage of the output voltage of the first feedforward amplifier and the output voltage of the second feedforward amplifier;
an error amplifier, a positive input port of the error amplifier being connected with the output common-mode voltage, a negative input port of the error amplifier being connected with the common-mode signal, an output port of the error amplifier generating control voltage;
a fifth resistor and a sixth resistor having the same parameters, one ends of the fifth resistor and the sixth resistor being connected to connect the control voltage output by the error amplifier, the other end of the fifth resistor being connected with the negative input port of the first feedforward amplifier and outputting compensation current to offset the leakage current of the negative input port of the first feedforward amplifier, the other end of the sixth resistor being connected with the negative input port of the second feedforward amplifier and outputting compensation current to offset the leakage current of the negative input port of the second feedforward amplifier.

4. The analog front-end circuit for the bioelectric sensor according to claim 3, wherein
the analog front-end circuit for the bioelectric sensor further comprises a fifth capacitor and a sixth capacitor having the same parameters;
one end of the fifth capacitor is connected with the negative input port of the first feedforward amplifier, and one end of the sixth capacitor is connected with the negative input port of the second feedforward amplifier; the other ends of the fifth capacitor and the sixth capacitor are connected to connect the common-mode voltage of the differential input signal or the control voltage generated by the error amplifier.

5. The analog front-end circuit for the bioelectric sensor according to claim 3, wherein
the third resistor is connected with a third capacitor in parallel; the fourth resistor is connected with a fourth capacitor in parallel; the third capacitor and the fourth capacitor have the same parameters.

6. The analog front-end circuit for the bioelectric sensor according to claim 3, wherein
the common-mode signal connected with the negative input port of the error amplifier is fixed nominal common-mode voltage; or the common-mode signal is the common-mode voltage of the differential input signal.

7. The analog front-end circuit for the bioelectric sensor according to claim 6, wherein
when the common-mode signal is the common-mode voltage of the differential input signal, the analog front-end circuit for the bioelectric sensor further comprises a seventh resistor and an eighth resistor symmetrical to each other;
one end of the seventh resistor is connected with the positive input port of the first feedforward amplifier, one end of the eighth resistor is connected with the positive input port of the second feedforward amplifier, and the other ends of the seventh resistor and the eighth resistor are connected to output the common-mode voltage of the differential input signal.

8. The analog front-end circuit for the bioelectric sensor according to claim 7, wherein
the first resistor, the second resistor, the third resistor, the fourth resistor, the fifth resistor, the sixth resistor, the seventh resistor and the eighth resistor are respectively implemented by devices or structures equivalent to resistor functions.

9. The analog front-end circuit for the bioelectric sensor according to claim 8, wherein
the devices or structures equivalent to resistor functions comprise pseudo-resistors.

10. The analog front-end circuit for the bioelectric sensor according to claim 9, wherein
each pseudo-resistor comprises an equivalent resistor structure based on PMOS transistors, or is formed by connecting a plurality of equivalent resistor structures based on PMOS transistors in series;
each equivalent resistor structure based on PMOS transistors is formed by back to back connecting PMOS devices connected by two diodes.
